(19) Europäisches Patentamt

European Patent Office

Office européen des brevets

(11) **EP 0 706 059 B1**

(12) **EUROPÄISCHE PATENTSCHRIFT**

(45) Veröffentlichungstag und Bekanntmachung des Hinweises auf die Patenterteilung:
**19.12.2001 Patentblatt 2001/51**

(51) Int Cl.$^7$: **G01R 35/00**

(21) Anmeldenummer: **95115296.6**

(22) Anmeldetag: **28.09.1995**

(54) **Verfahren zum Kalibrieren eines Netzwerk-Analysators nach dem 15-Term-Prinzip**

Calibrating procedure for a network analyzer using the 15-term principle

Procédure de calibration pour un analyseur de circuit selon le principe des 15-termes

(84) Benannte Vertragsstaaten:
**DE ES FR GB IT**

(30) Priorität: **05.10.1994 DE 4435559**

(43) Veröffentlichungstag der Anmeldung:
**10.04.1996 Patentblatt 1996/15**

(73) Patentinhaber:
 • **Rohde & Schwarz GmbH & Co. KG**
   **D-81671 München (DE)**
 • **Rosenberger Hochfrequenztechnik GmbH & Co.**
   **84526 Tittmoning (DE)**

(72) Erfinder:
 • **Heuermann, Holger, Dipl.-Ing.**
   **D-84529 Tittmoning (DE)**
 • **Schiek, Burkhard, Prof. Dr. Ing.**
   **D-44801 Bochum (DE)**

(74) Vertreter: **Körfer, Thomas, Dipl.-Phys. et al**
   **Mitscherlich & Partner, Patent- und**
   **Rechtsanwälte, Sonnenstrasse 33**
   **80331 München (DE)**

(56) Entgegenhaltungen:
   **EP-A- 0 568 889      DE-A- 3 912 795**
   **GB-A- 2 273 364      US-A- 4 982 164**

 • **22ND EUROPEAN MICROWAVE CONFERENCE 92, Bd. 2, 24. - 27.August 1992 TUNBRIDGE WELLS,GB, Seiten 907-912, XP 000337853 HEUERMANN ET AL. 'a generalization of the txx network analyser self-calibration procedure'**
 • **IEEE TRANS. ON MICROWAVE THEORY AND TECHNIQUES, Bd. 39, Nr. 4, April 1991 NEW YORK,US, Seiten 724-731, XP 000179068 EUL 'a generalized theory'**

**Beschreibung**

Die Erfindung betrifft ein Kalibrierverfahren laut Oberbegriff des Anspruches 1 bzw. 6.

Nach dem 15-Term-Prinzip arbeitende Kalibrierverfahren dieser Art sind bekannt (britische Patentschrift 2273 364). Bei diesem Kalibrierverfahren werden insgesamt 5 Kalibrierstandards benutzt, von denen sämtliche Streuparameter vollständig bekannt sein müssen. Dies setzt relativ teure und in der Herstellung aufwendige Kalibrierstandards voraus.

Für das sogenannte 7-Term-Kalibrierverfahren ist auch schon die sogenannte Selbstkalibrierung entwickelt worden, bei der zur Reduzierung der Anforderungen an die Kalibrierstandards einige ihrer Streuparameter unbekannt sein dürfen (US-Patent 4 982 164). Dieses bekannte Selbstkalibrierverfahren für das 7-Term-Prinzip ist für das 15-Term-Kalibrierverfahren in der bekannten Form nicht geeignet.

Es ist daher Aufgabe der Erfindung, ein Selbstkalibrierverfahren aufzuzeigen, das auch für das 15-Term-Kalibrierprinzip geeignet ist.

Diese Aufgabe wird ausgehend von einem bekannten Verfahren der eingangs erwähnten Art durch die kennzeichnenden Merkmale der Ansprüche 1 und 6 gelöst. Vorteilhafte Weiterbildungen ergeben sich jeweils aus den Unteransprüchen.

Beim erfindungsgemäßen Verfahren werden wie beim üblichen 15-Term-Verfahren fünf Kalibriermessungen zur Ermittlung der insgesamt 15 unbekannten Fehlerparameter eingesetzt, die Kalibrierstandards müssen jedoch nicht vollständig bekannt sein, es ist nur erforderlich, daß bis zu fünf unbekannte Streuparameter auf vier der fünf erforderlichen Kalibrierstandards verteilt werden. Nur einer der fünf erforderlichen Kalibrierstandards muß vollständig bekannt sein, wobei hierfür entweder ein aus zwei Wellensümpfen von bekanntem Widerstand, der auch die Bezugsimpedanz festsetzt, zusammengesetztes Doppeleintor (Anspruch 1) oder ein aus zwei Leerläufen bestehendes Doppeleintor (Anspruch 6) bekannter Reflexion benutzt wird. Beim erfindungsgemäßen Verfahren können also die verschiedenartigsten bekannten handelsüblichen Kalibrierstandards eingesetzt werden, wobei diese bezüglich ihrer Streuparameter nicht vollständig bekannt sein müssen, diese können vielmehr nach Abschluß des gesamten Kalibriervorgangs aus den insgesamt ermittelten Meßwerten im Sinne der nachfolgenden Beschreibung auf einfache Weise berechnet werden. Ein erfindungsgemäßes Verfahren ist also mit wesentlich geringerem Aufwand bezüglich der Kalibrierstandards durchführbar und besitzt trotzdem die vorteilhaften Eigenschaften des bekannten 15-Term-Verfahrens, das auch für Messungen geeignet ist, bei denen aufgrund elektrischer Verkopplungen der Meßspitzen Übersprechen zwischen denselben auftritt.

Das erfindungsgemäße Verfahren ist in den nachfolgenden Tabellen 1 bis 5 schematisch zusammengefaßt, die Tabelle 1 zeigt das grundsätzliche MURN-Kalibrierverfahren, die Tabelle 5 das vorteilhafte und mit reinen Serienwiderständen vor allem in Streifenleitungstechnik (On-Wafer-Messungen) realisierbare ZORN-Verfahren. In diesen Tabellen bedeuten S11 und S22 die komplexen Reflexionsfaktoren am Eingang und Ausgang eines Zweitores und S12 und S21 jeweils die Transmissionsfaktoren in Vorwärtsund Rückwärts-Richtung (Streuparameter). Die Doppelbuchstaben bezeichnen jeweils eine Doppeleintor-Kalibrierung, bei der ein Eintor der bezeichneten Art jeweils nacheinander an die beiden Meßtore angeschaltet wird, MM bedeutet also die Doppeleintor-Kalibrierung mit einem Wellensumpf M (Match) von bekanntem Widerstand und bekannter Reflexion. UU und RR bezeichnet jeweils einen Doppeleintor-Kalibrierstandard unbekannter Reflexion ρ bzw. γ, N1 und N2 bedeuten reziproke Zweitore unbekannter Reflexion ra, rb bzw. na, nb jedoch mit einer endlichen Transmission 1 bzw. t.

Aus der Tabelle 1 ist ersichtlich, daß bei den dort verwendeten fünf Standards MM, UU, RR, N1 und N2 insgesamt acht unbekannte Streuparameter gegeben sind, gemäß der Erfindung werden aus diesen insgesamt zur Verfügung stehenden Kalibrierstandards in beliebiger Kombination solche ausgewählt, daß nur noch fünf Streuparameter unbekannt sind, wie dies für das MORN-, TMRM- und MONS-Verfahren nach den Tabellen 2, 3 und 4 für drei Beispiele dargestellt ist, wobei L eine elektrische Leitung von bekanntem Wellenwiderstand, jedoch von unbekannter Ausbreitungskonstante bezeichnet und T eine direkte Verbindung der beiden Meßtore (Through-Connection). SS ist ein Doppeleintor-Kurzschluß und UR ein reziprokes Zweitor unbekannter Reflexion ra bzw. rb.

In gleicher Weise können aus den in Tabelle 5 für das ZORN-Verfahren aufgeführten fünf Kalibrierstandards jeweils solche ausgewählt werden, daß von den laut Tabelle 5 wiederum insgesamt acht unbekannten Streuparametern nur fünf unbekannt sind, womit dann ebenfalls das erfindungsgemäße Verfahren durchführbar ist. In all diesen Fällen werden nach Abschluß sämtlicher Kalibriermessungen aus den insgesamt zwanzig zur Verfügung stehenden Meßwerten die noch unbekannten fünf Streuparameter und dann schließlich in bekannter Weise die eigentlichen Korrekturwerte berechnet, die dann im Netzwerkanalysator abgespeichert und bei nachfolgenden Objektmessungen entsprechend berücksichtigt werden.

Die Erfindung wird im folgenden anhand schematischer Zeichnungen an Ausführungsbeispielen näher erläutert.

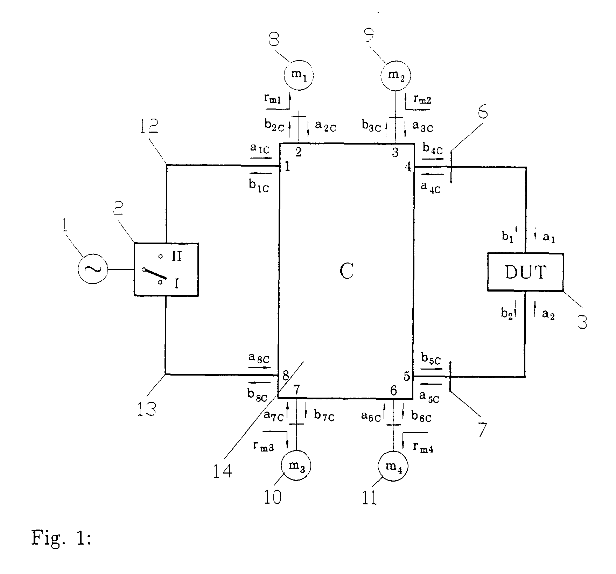

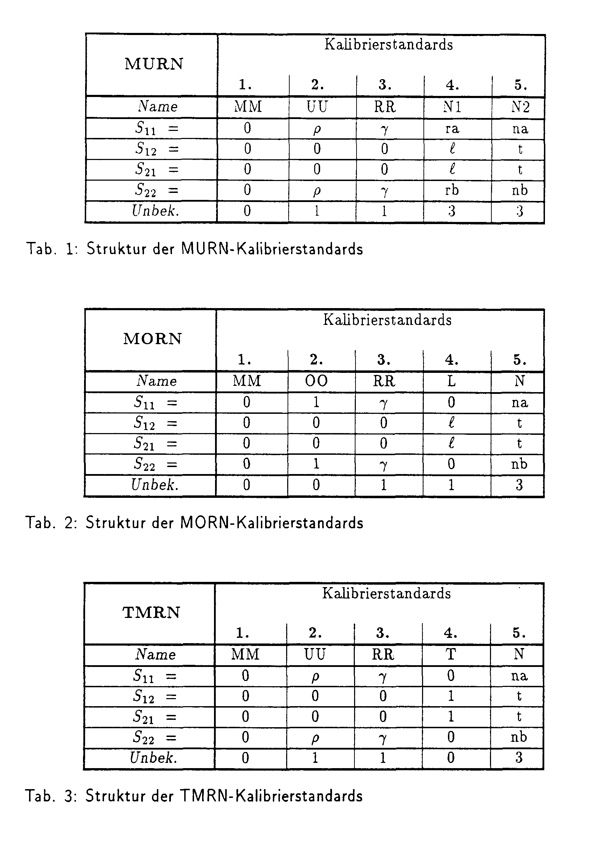

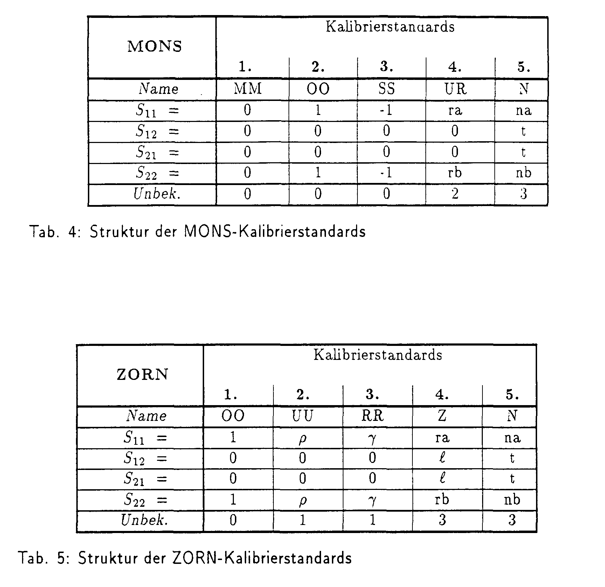

Fig. 1 zeigt ein stark vereinfachtes Prinzipschaltbild eines Netzwerkanalysators (NWA), bei dem über einen Umschalter 2 zwei Meßzweige 12 und 13 aus einem Hochfrequenzgenerator 1 gespeist sind. Diese Meßzweige münden in dem Achttor 14, von dem ein lineares Übertragungsverhalten und zusätzlich eine Entkopplung der Meßstellen 8, 9, 10 und 11 verlangt wird. Im Falle vom Streuparametermessungen ist es vorteilhaft, wenn dieses Achttor allseitige Anpassung aufweist und Brücken zur Signalflußtrennung beinhaltet, so daß beispielsweise die Meßstelle 8 ein Maß für die hinlaufende Welle aus dem Zweig 12 bildet und die Meßstelle 9 ein Maß für die vom Meßobjekt 3 durch das Meßtor 6 zulaufende Welle bildet. Möchte man jedoch Impedanzparameter aufnehmen, so kann ein derartiges niederohmiges Testset ungünstig sein. Wie auch immer, sofern die Entkopplung der Meßstellen und ein lineares Übertragungsverhalten des Achttores 14 gesichert sind, kann durch Einsatz eines Systemfehlerkorrekturverfahrens auf jede lineare Beschreibungsform von Netzwerken übergegangen werden.

Die Meßtore 6 und 7 bilden den Übergang zu dem Meßobjekt 3 und werden auch als Referenzebenen bezeichnet.

Nach dem sogenannten Vollmodell (15-Term Modell) werden hierbei die zwischen den Meßpunkten 8, 9, 10 und 11 und dem an den eigentlichen Meßtoren 6 und 7 angeschalteten Meßobjekt 3 auftretenden Störgrößen, die bei spielsweise durch die zum Meßobjekt führenden Verbindungsleitungen, Fehlanpassungen und unerwünschte Verkopplungen verursacht werden, durch sogenannte Fehlernetzwerke berücksichtigt, die durch ein Kalibrierverfahren ermittelt und bei der eigentlichen Messung als Korrekturwerte berücksichtigt werden.

Bei der Kalibriermessung wird das Meßobjekt 3 durch Kalibrierstandards ersetzt und es werden dann wiederum pro Standard vier Meßwerte für jede Schalterstellung des Umschalters 2 erfaßt.

<u>Grundlegende Herleitung für die 15-Term Verfahren</u>

Die mathematische Beschreibung sowohl der direkten 15-Term Verfahren als auch der folgenden Selbstkalibrierverfahren bildet das Fehlermodell nach Fig. 1.

Nach einer Achttor-Viertor-Reduktion der physikalischen Größen der Meßanordnung zu einer Abbildung aller vier elektrischen Größen an den Meßtoren zu den vier Meßstellen, erhält man eine mathematische Formulierung des Vollmodells,

$$
\begin{pmatrix} a_3 \\ a_4 \\ b_3 \\ b_4 \end{pmatrix} = \begin{bmatrix} & \mathbf{C} & \end{bmatrix} \begin{pmatrix} a_1 \\ a_2 \\ b_1 \\ b_2 \end{pmatrix} \quad , \tag{1}
$$

die in diesem Fall Wellengrößen an den Meßtoren und Meßstellen ansetzt. Zerlegt man die $4*4$ Fehlermatrix $[\mathbf{C}]$ in vier 2*2 Matrizen, so gelangt man mittels

$$
\begin{bmatrix} & \mathbf{C} & \end{bmatrix} = \begin{pmatrix} [\mathbf{A}] & [\mathbf{E}] \\ [\mathbf{F}] & [\mathbf{B}] \end{pmatrix} \tag{2}
$$

zu zwei Matrizengleichungen:

$$
[\mathbf{A}] \begin{pmatrix} a_1 \\ a_2 \end{pmatrix} + [\mathbf{E}] \begin{pmatrix} b_1 \\ b_2 \end{pmatrix} = \begin{pmatrix} a_3 \\ a_4 \end{pmatrix} \quad , \tag{3}
$$

$$
[\mathbf{B}] \begin{pmatrix} b_1 \\ b_2 \end{pmatrix} + [\mathbf{F}] \begin{pmatrix} a_1 \\ a_2 \end{pmatrix} = \begin{pmatrix} b_3 \\ b_4 \end{pmatrix} \quad . \tag{4}
$$

Greift man auf den Zusammenhang in Streuparametern

$$\begin{pmatrix} a_3 \\ a_4 \end{pmatrix} = [\mathbf{Sx}] \begin{pmatrix} b_3 \\ b_4 \end{pmatrix} \tag{5}$$

für das Meßobjekt (DUT) zurück und setzt die Matrixgleichungen (3) und (4) in die Gleichung (5) ein, so läßt sich die Gleichung (6) gewinnen.

$$[\mathbf{A}] \begin{pmatrix} a_1 \\ a_2 \end{pmatrix} + [\mathbf{E}] \begin{pmatrix} b_1 \\ b_2 \end{pmatrix} = [\mathbf{Sx}][\mathbf{B}] \begin{pmatrix} b_1 \\ b_2 \end{pmatrix} + [\mathbf{Sx}][\mathbf{F}] \begin{pmatrix} a_1 \\ a_2 \end{pmatrix} \tag{6}$$

Diese Vektorgleichung beschreibt eine bilineare Abbildung der Streuparameterwerte des Meßob jektes auf die Meßwerte für eine Schalterstellung des Umschalters 2. Die Veränderung des sogenannten Testset-Schalters liefert eine zweite von der ersten unabhängige Abbildung bei unverändertem Fehlernetzwerk.
Aus den Messungen von fünf verschiedenen vollständig bekannten Meßobjekten können die Fehlergrößen der Fehlermatrizen [**A**], [**B**], [**E**] und [**F**] berechnet werden.
Für ein sogenanntes Selbstkalibrierverfahren erfolgt die Vereinigung der beiden Vektorgleichungen aus (6) für die beiden Schalterstellungen zu

$$[A] + [E] [Mx] = [Sx] ([B] [Mx] + [F]) \tag{7}$$

mit der Meßwertmatrix

$$[\mathbf{Mx}] = \begin{pmatrix} b_1' & b_1'' \\ b_2' & b_2'' \end{pmatrix} \begin{pmatrix} a_1' & a_1'' \\ a_2' & a_2'' \end{pmatrix}^{-1} \quad . \tag{8}$$

Die MURN-Verfahren

Obwohl die direkten 15-Term Verfahren erst seit kurzer Zeit bekannt sind, stehen on-wafer-Kalibrierstandards zur Verfügung. Diese Substrate werden zwar bisher für das 12-Term und das LRM-Verfahren eingesetzt, weisen jedoch schon die notwendigen Doppeleintor-Kalibrierstandards auf.
Deshalb wollen wir uns zunächst mit einer allgemeinen Theorie beschäftigen, die Selbstkalibrierverfahren hervorbringt, die Standards benötigen, die auf derartig kommerziell erhältlichen Kalibriersubstraten zu finden sind.

*Herleitung der allgemeinen MURN-Selbstkalibrierung*

Für die Herleitung des allgemeinen MURN-Verfahrens sollen die fünf Kalibrierstandards zunächst acht unbekannte Parameter enthalten. Die Struktur der Kalibrierstandards ist in der Tabelle 1 angegeben.
Fundierend auf den Ergebnissen dieser allgemeinen Herleitung können eine Reihe von speziellen Kalibrierverfahren durch die Reduktion der acht auf die nur möglichen fünf unbekannten Parametern abgeleitet werden.
Setzt man für die fünf Kalibriermessungen die Werte der Kalibrierstandards gemäß der Tabelle 1 in die Gleichung (7) ein, so erhält man das folgende Gleichungssystem.

$$MM : [A] + [E] [M1] = 0 \tag{9}$$

$$UU : [A] + [E] [M2] = \rho ([B] [M2] + [F]) \tag{10}$$

$$RR : [A] + [E]\,[M3] = \gamma\,([B]\,[M3] + [F]) \tag{11}$$

$$N1 : [A] + [E]\,[M4] = [N1]\,([B]\,[M4] + [F]) \tag{12}$$

$$N2 : [A] + [E]\,[M5] = [N2]\,([B]\,[M5] + [F]) \tag{13}$$

In einem ersten Schritt wird mittels Gleichung (9) die Matrix [**A**] in den restlichen Gleichungen eliminiert. In einem zweiten Schritt wird mit Hilfe der modifizierten Gleichung (12) die Fehlermatrix [**F**] in den modifizierten Gleichungen (10) und (11) ersetzt. In gleicher Art und Weise ersetzt man unter Verwendung der Gleichung (13) die Matrix [**F**] in den Gleichungen (10) und (11). Somit erhält man vier Gleichungen mit den unbekannten Fehlermatrizen [B] und [**E**].

$$\frac{1}{\rho}\,[E]\,[Ma] + [N1]^{-1}\,[E]\,[Mb] = [B] \tag{14}$$

$$\frac{1}{\gamma}\,[E]\,[Mc] + [N1]^{-1}\,[E]\,[Md] = [B] \tag{15}$$

$$\frac{1}{\rho}\,[E]\,[Me] + [N2]^{-1}\,[E]\,[Mf] = [B] \tag{16}$$

$$\frac{1}{\gamma}\,[E]\,[Mg] + [N2]^{-1}\,[E]\,[Mh] = [B] \tag{17}$$

Die in den Gleichungen (14) bis (17) angegebenen Meßwertmatrizen ergeben sich aus den ursprünglichen Meßwerten wie folgt:

$$[Ma] = ([M2] - [M1])\,([M2] - [M4])^{-1}\,, \tag{18}$$

$$[Mb] = ([M1] - [M4])\,([M2] - [M4])^{-1}\,, \tag{19}$$

$$[Mc] = ([M3] - [M1])\,([M3] - [M4])^{-1}\,, \tag{20}$$

$$[Md] = ([M1] - [M4])\,([M3] - [M4])^{-1}\,, \tag{21}$$

$$[Me] = ([M2] - [M1])\,([M2] - [M5])^{-1}\,, \tag{22}$$

$$[Mf] = ([M1] - [M5])\,([M2] - [M5])^{-1}\,, \tag{23}$$

$$[Mg] = ([M3] - [M1])\,([M3] - [M5])^{-1}\,, \tag{24}$$

$$[Mh] = ([M1] - [M5])\,([M3] - [M5])^{-1}\,. \tag{25}$$

Setzt man Gleichung (14) und (15) gleich, so erhält man nach einer geeigneten Umformung die erste für die Selbstkalibrierung wichtige Ähnlichkeitstransformation, Gleichung (26). Verfährt man genauso mit den Gleichungen (16) und (17), so gelangt man zur zweiten Transformationsgleichung, (27). Eine Multiplikation dieser beiden Transformationen liefert die dritte notwendige Ähnlichkeitstransformation, (28).

$$\frac{1}{\rho}[Mu] - \frac{1}{\gamma}[Mv] = [E]^{-1}[N1]^{-1}[E] \tag{26}$$

$$\frac{1}{\rho}[Mw] - \frac{1}{\gamma}[Mx] = [E]^{-1}[N2]^{-1}[E] \tag{27}$$

$$\left(\frac{1}{\rho}[\mathbf{Mu}] - \frac{1}{\gamma}[\mathbf{Mv}]\right)\left(\frac{1}{\rho}[\mathbf{Mw}] - \frac{1}{\gamma}[\mathbf{Mx}]\right) = [\mathbf{E}]^{-1}[\mathbf{N1}]^{-1}[\mathbf{N2}]^{-1}[\mathbf{E}] \tag{28}$$

Die Meßwerte wurden erneut wie folgt zusammengefaßt:

$$[Mu] = [Ma]\,([Md] - [Mb])^{-1}, \tag{29}$$

$$[Mv] = [Mc]\,([Md] - [Mb])^{-1}, \tag{30}$$

$$[Mw] = [Me]\,([Mh] - [Mf])^{-1}, \tag{31}$$

$$[Mx] = [Mg]\,([Mh] - [Mf])^{-1}. \tag{32}$$

Die Ausnutzung der Eigenschaften einer Ähnlichkeitstransformation, Äquivalenz der Spur und der Determinante des Transformationspaares für die Gleichungen (26) und (27) und lediglich der Spuräquivalenz der Gleichung (28) liefert fünf nichtlineare Gleichungen für fünf mögliche unbekannte Parameter in den Kalibrierstandards.

$$\frac{1}{\rho}(Mu_{11} + Mu_{22}) - \frac{1}{\gamma}(Mv_{11} + Mv_{22}) = \mathrm{spur}\,([N1]^{-1}) \tag{33}$$

$$\frac{1}{\rho^2}ua + \frac{1}{\gamma^2}va - \frac{1}{\rho\gamma}ub = \det\,([N1]^{-1}) \tag{34}$$

$$\frac{1}{\rho}(Mw_{11} + Mw_{22}) - \frac{1}{\gamma}(Mx_{11} + Mx_{22}) = \mathrm{spur}\,([N2]^{-1}) \tag{35}$$

$$\frac{1}{\rho^2}wa + \frac{1}{\gamma^2}xa - \frac{1}{\rho\gamma}wb = \det\,([N2]^{-1}) \tag{36}$$

$$\frac{1}{\rho^2}xb + \frac{1}{\gamma^2}xc - \frac{1}{\rho\gamma}xd = \mathrm{spur}\,([N1]^{-1}[N2]^{-1}) \tag{37}$$

Dieses Gleichungssystem enthält folgende Abkürzungen für die Meßwertmatrizen:

$$ua = \det([Mu]), \tag{38}$$

$$va = \det([Mv]), \tag{39}$$

$$wa = \det([Mw]), \tag{40}$$

$$xa = \det([Mx]), \tag{41}$$

$$ub = Mu_{11} * Mv_{22} + Mu_{22} * Mv_{11} - Mu_{21} * Mv_{12} - Mu_{12} * Mv_{21}, \tag{42}$$

$$wb = Mw_{11} * Mx_{22} + Mw_{22} * Mx_{11} - Mw_{21} * Mx_{12} - Mw_{12} * Mx_{21}, \tag{43}$$

$$xb = Mu_{11} * Mw_{22} + Mu_{22} * Mw_{11} + Mu_{21} * Mw_{12} + Mu_{12} * Mw_{21}, \tag{44}$$

$$xc = Mv_{11} * Mx_{22} + Mv_{22} * Mx_{11} + Mv_{21} * Mx_{12} + Mv_{12} * Mx_{21}, \tag{45}$$

$$xd = Mu_{11} * Mx_{11} + Mv_{11} * Mw_{11} + Mu_{12} * Mx_{21} + Mv_{12} * Mw_{21} +$$

$$Mu_{21} * Mx_{12} + Mv_{21} * Mw_{12} + Mu_{22} * Mx_{22} + Mv_{22} * Mw_{22}. \tag{46}$$

Stellt man dieses nichtlineare Gleichungssystem für diesen hier angegebenen allgemeinen Fall auf, so erkennt man, daß es sich um ein homogenes Gleichungssystem handelt. Diese Tatsache erfordert, daß ein weiterer Zweitor- oder Doppeleintor-Kalibrierstandard vollständig bekannt ist. Würde man Kalibrierverfahren für den koaxialen Bereich herleiten, so wäre eine bekannte Durchverbindung (T) der ideale bekannte Kalibrierstandard. Da jedoch der endliche Abstand der Meßspitzen keine direkte Durchverbindung erlaubt, ist diese Vorgehensweise für on-wafer-Messungen fehlangebracht. Für das Vollmodell ist hingegen der Leerlauf ein postulierter Kalibrierstandard, weil sämtliche Nichtidealitäten des Leerlaufes Elemente des Vollmodells sind. Aus diesem Grund ersetzt man für on-wafer-Messungen den Doppeleintorstandard RR durch den bekannten Standard 00.
Eine zweite Einschränkung der Möglichkeiten der allgemeine Theorie der MURN-Kalibriertechnik findet man, indem man den Rang der 15*15 Matrix zur Bestimmung der Fehlerkoeffizienten untersucht. Eine derartige Rang-Untersuchung bringt hervor, daß im Kalibrierprozeß ein reflexionsunsymmetrischer Kalibrierstandard enthalten sein muß. Da on-wafer-Messungen mit möglichst wenig Kalibrierschritten auskommen sollen, sollen an dieser Stelle auch nur Selbstkalibrierverfahren hergeleitet werden, die diese Forderung erfüllen.
Daß sich trotz dieser Einschränkungen eine Reihe von interessanten Kalibrierverfahren herleiten lassen, soll nun anhand des MORN-Verfahrens bei vollständiger Herleitung und durch die Vorstellung weiterer getesteter Verfahren demonstriert werden.

*Herleitung des MORN-on-wafer-Selbstkalibrierverfahrens*

Bei dem MORN-Kalibrierverfahren handelt es sich um eine besondere Auswahl von Kalibrierstandards aus der Theorie für die allgemeine MURN-Selbstkalibriertechnik, die für on-wafer-Meßprobleme sehr interessante Möglichkeiten einerseits zur Kontrolle des Kalibriervorganges und andererseits in der Herstellbarkeit der Kalibrierstandards bietet. Die Eigenschaften der MORN-Kalibrierstandards sind der Tabelle 2 zu entnehmen.
Sowohl der R-Kalibrierstandard als auch der reflexionsunsymmetrische N-Standard eignen sich hervorragend für eine Selbstkontrolle, indem beispielsweise nahezu bekannte Objekte wie Kurzschlüsse für den R-Standard und der zuvor ausführlich diskutierte unsymmetrische ZY-Standard für den N-Standard eingesetzt werden.
Für eine große Anzahl von Messungen ist die Kenntnis der Ausbreitungskonstante der Leitungen sehr wichtig. Diese kann mit dem MORN-Verfahren in einfacher Art und Weise mittels einer kurzen Leitung (L: Line) anstelle des N1-Standards detektiert werden. Unter Verwendung dieser teilweise bekannten Kalibrierstandards für das Gleichungssystem (33) - (37) ergibt sich das vereinfachte Gleichungssystem zur Bestimmung der sogenannten Selbstkalibriergrößen:

$$Mu_{11} + Mu_{22} - \frac{1}{\gamma}(Mv_{11} + Mv_{22}) = 0, \tag{47}$$

$$\underbrace{ua + \frac{1}{\gamma^2}va - \frac{1}{\gamma}ub}_{=ya} \qquad = \frac{1}{\ell^2} \ , \qquad\qquad (48)$$

$$\underbrace{Mw_{11} + Mw_{22} - \frac{1}{\gamma}(Mx_{11} + Mx_{22})}_{=yb} \quad = na' + nb' \quad , \qquad\qquad (49)$$

$$\underbrace{wa + \frac{1}{\gamma^2}xa - \frac{1}{\gamma}wb}_{=yc} = na' \, nb' - t'^2 \quad , \qquad\qquad (50)$$

$$\underbrace{xb + \frac{1}{\gamma^2}xc - \frac{1}{\rho\gamma}xd}_{=yd} \qquad = \frac{2\,t'}{\ell} \ . \qquad\qquad (51)$$

Nach kurzer Zwischenrechnung erhält man aus diesem größtenteils entkoppelten System nichtlinearer Gleichungen die einfachen Endgleichungen zur Bestimmung der Selbstkalibriergrößen:

$$\gamma = \frac{Mv_{11} + Mv_{22}}{Mu_{11} + Mu_{22}} \qquad\qquad (52)$$

$$\ell = \pm \sqrt{\frac{1}{ya}}, \qquad\qquad (53)$$

$$t' = \frac{\ell yd}{2}, \qquad\qquad (54)$$

$$na' = \frac{yb}{2} \pm \sqrt{\frac{yb^2}{4} - t'^2 - yc}, \qquad\qquad (55)$$

$$nb' = yb - na' \ . \qquad\qquad (56)$$

Die Größen für das reziproke Netzwerk N ergeben sich schlußendlich durch eine Invertierung der sich aus dem Selbstkalibrierprozeß berechneten mit Strichen gekennzeichneten

$$\begin{pmatrix} na & t \\ t & nb \end{pmatrix} = \begin{pmatrix} na' & t' \\ t' & nb' \end{pmatrix}^{-1} \cdot \qquad\qquad (57)$$

*Diskussion weiterer 15-Term Selbstkalibrierverfahren*

Welche Leistungsfähigkeit diese neuen 15-Term Selbstkalibrierverfahren bieten, das sollen die für den koaxialen Einsatz besonders geeigneten TMRN-Verfahren demonstrieren (Tabelle 3). Neben den zwei weiteren Kalibriermessungen an jedoch unbekannten Standards setzt dieses Verfahren im Hinblick auf die Kalibrierstandards nicht mehr Informationen voraus, als die bekannten 7-Term Verfahren für ein unverkoppeltes Doppelreflektometer erfordern. Dieses TMRN-Verfahren ist dann besonders geeignet, wenn es gilt Übersprecher innerhalb des NWA zu ermitteln. Bei kommerziell erhältlichen Kalibriersubstraten wurde ein großer Wert auf die exakte Fertigung der Reflexionsstandards Leerlauf und Kurzschluß gelegt. Verfügt man über ein derartiges Kalibriersubstrat, so kann das als MONS bezeichnete und in Tabelle 4 vorgestellte Selbstkalibrierverfahren von großen Interesse sein.

Dieses MONS-Verfahren weicht jedoch etwas von der Herleitung des allgemeinen MURN-Verfahrens ab, da dieses Verfahren nur noch ein Zweitor enthält. Da bei diesem Verfahren N1 ein Doppeleintor-Standard ist, kann dessen Matrix nicht mehr invertiert werden, wie es in der Gleichung (27) durchgeführt wurde. Weil jedoch die beiden Größen $\gamma$ und $\rho$ des MURN-Verfahrens vollständig bekannt sind, kann eine Invertierung der anderen Seite dieser Matrixgleichung durchgeführt werden.

Die ZORN-Verfahren

Die ZORN-Verfahren bieten gegenüber den MURN-Verfahren interessante Vorteile. Im folgenden möchten wir eine allgemeine Herleitung von ZORN-Verfahren für das 15-Term Modell vorstellen, die den M durch einen ZY- bzw. Z-Standard ersetzen.

In Tabelle 5 sind die Standards in Streuparametern angegeben, obwohl für die Rechnung Y-Parameter verwendet werden.

Bei den Meßgrößen muß es sich nicht um Wellengrößen handeln. Stattdessen können diese allgemein behandelt werden, oder als Ströme und Spannungen aufgefaßt werden. Folglich läßt sich die Transformationsmatrix des Vollmodells in der Form von Gleichung (58).

$$\begin{pmatrix} i_3 \\ i_4 \\ u_3 \\ u_4 \end{pmatrix} = \begin{bmatrix} \mathbf{C} \end{bmatrix} \begin{pmatrix} u_1 \\ u_2 \\ i_1 \\ i_2 \end{pmatrix} \quad , \tag{58}$$

und das Meßobjekt in Y-Parametern darstellen.

$$\begin{pmatrix} i_3 \\ i_4 \end{pmatrix} = \begin{bmatrix} \mathbf{Yx} \end{bmatrix} \begin{pmatrix} u_3 \\ u_4 \end{pmatrix} \tag{59}$$

In Analogie zur Herleitung der Gleichung (7), gelangt man mit den Gleichungen (58) und (59) zu einer Abbildungsgleichung gleicher Struktur, jedoch nunmehr nicht in Streusondern Y-Parametern.

Setzt man die in der Tabelle 5 angegebenen Werte für die Kalibrierstandards ein, so ergeben sich die folgenden fünf Matrizengleichungen zur Ermittlung der Selbstkalibriergrößen.

$$OO : [A] + [E] [M1] = 0 \tag{60}$$

$$UU : [A] + [E] [M2] = ya ([B] [M2] + [F]) \tag{61}$$

$$RR : [A] + [E] [M3] = yb ([B] [M3] + [F]) \tag{62}$$

$$N : [A] + [E] [M4] = [N] ([B] [M4] + [F]) \tag{63}$$

$$Z : [A] + [E] [M5] = [Z] ([B] [M5] + [F]) \tag{64}$$

Die Ähnlichkeit zwischen diesen fünf Gleichungen und den Ausgangsgleichungen (9)-(13) des MURN-Verfahrens ist unverkennbar. Folglich lassen sich die Selbstkalibriergleichungen der ZORN-Verfahren auf denselben Weg und mit denselben Abkürzungen für die Meßwertmatrizen herleiten.

$$ya(Mu_{11} + Mu_{22}) - yb\,(Mv_{11} + Mv_{22}) = \text{spur}\,([Z]^{-1}) \tag{65}$$

$$ya^2\,ua + yb^2\,va - ya\,yb\,ub = \det\,([Z]^{-1}) \tag{66}$$

$$ya\,(Mw_{11} + Mw_{22}) - yb\,(Mx_{11} + Mx_{22}) = \text{spur}\,([N]^{-1}) \tag{67}$$

$$ya^2\,wa + yb^2\,xa - ya\,yb\,wb = \det\,([N]^{-1}) \tag{68}$$

$$ya^2\,xb + yb^2\,xc - ya\,yb\,xd = \text{spur}\,([Z]^{-1}\,[N]^{-1}) \tag{69}$$

In diesem nichtlinearen Gleichungssystem müssen mindestens drei der acht unbekannten Streuparametergrößen bekannt sein. Eine praktisch sehr interessante Variante zur Realisierung des Z- und des N-Kalibrierstandards besteht darin, daß man den Realteil von zwei Impedanzen, die in Serie geschaltet sind, kennt. Jedoch erkennt man, daß in diesem Fall das Gleichungssystem nur noch numerisch lösbar ist. Dieses stellt in der Regel keine große Einschränkung dar, da man bei hochwertigen Kalibriersubstraten über gute Startwerte bezüglich der Impedanzen verfügt. Kennt man hingegen zwei Impedanzen vollständig, so findet man auch eine geschlossene Lösung. Da diese Bestimmungsgleichungen auch für vier unbekannte Impedanzwerte sehr lang werden, soll an dieser Stelle auf die Angabe eines Beispieles verzichtet werden. Selbstverständlich ist, daß einzelne Impedanzen in den Kalibrierstandards gar nicht enthalten sein müssen. So könnte man die ZY-Standards durch Z- oder Y-Standards ersetzen. Wichtig ist letztendlich nur, daß der Rang der Matrix zur Bestimmung der Fehlergrößen immer 15 ist. Dafür ist es unerläßlich einen reflexionsunsymmetrischen Kalibrierstandard zu verwenden.

Man könnte bei einem Vergleich der MURN- und der ZORN-Verfahren meinen, daß die ZORN-Verfahren unattraktiver seien, da sie einen vollständig bekannten O-Standard benötigen. Jedoch ist dieser O-Standard, wie schon diskutiert, postuliert. Dieses gilt jedoch nur für das Vollmodell, da nur bei diesem sämtliche Nichtidealitäten des Leerlaufes in die Fehlerkoeffizienten eingehen.

Hat man diesen Aspekt erkannt, so sieht man daß das ZORN-Verfahren mit all seinen Freiheitsgraden, sofern die geeigneten Kalibriersubstrate zur Verfügung stehen, die bessere Alternative darstellt.

**Patentansprüche**

1. Verfahren zum Kalibrieren eines zwei Meßtore (6,7) und mindestens vier Meßstellen (8,9,10,11) aufweisenden Netzwerk-Analysators durch aufeinanderfolgende Messung der Transmissions- und Reflexions-Parameter an fünf in beliebiger Reihenfolge nacheinander zwischen die beiden Meßtore (6,7) geschalteten Kalibrierstandards nach dem 15-Term-Prinzip, wobei aus diesen Meßwerten Korrekturwerte berechnet werden, die bei nachfolgenden Objektmessungen berücksichtigt werden, bei dem für die erste Kalibriermessung als Kalibrierstandard ein Eintor mit bekanntem Widerstand benutzt wird, das nacheinander an die beiden Meßtore (6,7) angeschaltet wird,
**dadurch gekennzeichnet,**
**daß**

eine zweite Kalibriermessung an einem reflexionssymmetrischen Doppeleintor unbekannter Reflexion,

eine dritte Kalibriermessung an einem weiteren reflexionssymmetrischen Doppeleintor unbekannter, jedoch von der Reflexion des Doppeleintores der zweiten Kalibriermessung unterschiedlicher Reflexion

eine vierte Kalibriermessung an einem reziproken Zweitor unbekannter Reflexion

und eine fünfte Kalibriermessung an einem weiteren reziproken Zweitor von bekannter Transmission und unbekannter, jedoch von der Reflexion des Zweitores der vierten Kalibriermessung unterschiedlicher Reflexion durchgeführt wird,

und die unbekannten Streuparameter der zweiten, dritten, vierten und fünften Kalibriermessung aus den insgesamt gemessenen Meßwerten anschließend berechnet werden.

**2.** Verfahren nach Anspruch 1,
**dadurch gekennzeichnet,**
**daß** die zweite Kalibriermessung an einem Doppeleintor-Leerlauf durchgeführt wird.

**3.** Verfahren nach Anspruch 2,
**dadurch gekennzeichnet,**
**daß** die vierte Kalibriermessung an einer elektrischen Leitung mit bekanntem Wellenwiderstand durchgeführt wird, deren elektrische Ausbreitungskonstante unbekannt sein darf.

**4.** Verfahren nach Anspruch 2,
**dadurch gekennzeichnet,**
**daß** die dritte Kalibriermessung an einem Doppeleintor-Kurzschluß durchgeführt wird.

**5.** Verfahren nach Anspruch 1,
**dadurch gekennzeichnet,**
**daß** die vierte Kalibriermessung bei einer direkten Verbindung der beiden Meßtore durchgeführt wird.

**6.** Verfahren zum Kalibrieren eines zwei Meßtore (6,7) und mindestens vier Meßstellen (8,9,10,11) aufweisenden Netzwerk-Analysators durch aufeinanderfolgende Messung der Transmissions- und Reflexions-Parameter an fünf in beliebiger Reihenfolge nacheinander zwischen die beiden Meßtore (6,7) geschalteten Kalibrierstandards nach dem 15-Term-Prinzip, wobei aus diesen Meßwerten Korrekturwerte berechnet werden, die bei nachfolgenden Objektmessungen berücksichtigt werden, bei dem für die erste Kalibriermessung als Kalibrierstandard ein Leerlauf-Eintor benutzt wird, das nacheinander an die beiden Meßtore (6,7) angeschaltet wird,
**dadurch gekennzeichnet,**
**daß**

eine zweite Kalibriermessung an einem reflexionssymmetrischen Doppeleintor, das an jedem Tor den gleichen, jedoch unbekannten Impedanzwert aufweist,

eine dritte Kalibriermessung an einem weiteren reflexionssymmetrischen Doppeleintor, das an jedem Tor den gleichen, unbekannten, jedoch vom Impedanzwert der zweiten Kalibriermessung unterschiedlichen Impedanzwert aufweist,

eine vierte Kalibriermessung an einem Zweitor, das aus einer konzentrierten komplexen, jedoch unbekannten Serien- und/oder Parallelimpedanz besteht,

und eine fünfte Kalibriermessung an einem weiteren Zweitor, das aus einer konzentrierten Parallelimpedanz und einer konzentrierten unbekannten Serienimpedanz besteht,

durchgeführt wird,

und die unbekannten Streuparameter der zweiten, dritten, vierten und fünften Kalibriermessung aus den insgesamt gemessenen Meßwerten anschließend berechnet werden.

**7.** Verfahren nach Anspruch 6,
**dadurch gekennzeichnet,**
**daß** eines der Zweitore der vierten oder fünften Kalibriermessung durch einen bekannten Serienwiderstand gebildet ist.

**8.** Verfahren nach Anspruch 6,
**dadurch gekennzeichnet,**
**daß** eines der Zweitore für die vierte oder fünfte Kalibriermessung eine elektrische Leitung von bekanntem Wellenwiderstand ist, deren elektrische Ausbreitungskonstante unbekannt sein darf.

**9.** Verfahren nach Anspruch 3 oder 8,

**dadurch gekennzeichnet,**

**daß** als elektrische Leitung eine planare Streifenleitung benutzt wird.

**Claims**

1. A procedure for calibrating a network analyzer comprising two measuring ports (6, 7) and at least four measuring points (8, 9, 10, 11) by consecutive measurement of the transmission and reflection parameters in respect of five calibration standards connected in succession in arbitrary sequence between the two measuring ports (6, 7), in accordance with the 15-term principle, whereby correction values which are taken into account in subsequent object measurements are calculated from these measured values, wherein a one-port network with known resistance is utilised by way of calibration standard for the first calibration measurement, which is switched in succession to the two measuring ports (6, 7),
   **characterised in that**

   a second calibration measurement is carried out in respect of a reflection-symmetrical double one-port network of unknown reflection,

   a third calibration measurement is carried out in respect of a further reflection-symmetrical double one-port network with reflection which is unknown but which differs from the reflection of the second calibration measurement,

   a fourth calibration measurement is carried out in respect of a reciprocal two-port network of unknown reflection,

   and a fifth calibration measurement is carried out in respect of a further reciprocal two-port network of known transmission and with reflection which is unknown but which differs from the reflection of the two-port network of the fourth calibration measurement,

   and the unknown scattering parameters of the second, third, fourth and fifth calibration measurements are subsequently calculated from the measured values measured overall.

2. Procedure according to Claim 1,
   **characterised in that**
   the second calibration measurement is carried out in respect of an open-circuit operation of a double one-port network.

3. Procedure according to Claim 2,
   **characterised in that**
   the fourth calibration measurement is carried out in respect of an electrical line with known natural impedance, the electrical propagation constant of which may be unknown.

4. Procedure according to Claim 2,
   **characterised in that**
   the third calibration measurement is carried out in respect of a short-circuit of a double one-port network.

5. Procedure according to Claim 1,
   **characterised in that**
   the fourth calibration measurement is carried out in the case of a direct connection of the two measuring ports.

6. A procedure for calibrating a network analyzer comprising two measuring ports (6, 7) and at least four measuring points (8, 9, 10, 11) by consecutive measurement of the transmission and reflection parameters in respect of five calibration standards connected in succession in arbitrary sequence between the two measuring ports (6, 7), in accordance with the 15-term principle, whereby correction values which are taken into account in subsequent object measurements are calculated from these measured values, wherein for the first calibration measurement an open-circuit one-port network is utilised by way of calibration standard, which is switched in succession to the two measuring ports (6, 7),
   **characterised in that**

a second calibration measurement is carried out in respect of a reflection-symmetrical double one-port network that exhibits the same but unknown impedance value at each port,

a third calibration measurement is carried out in respect of a further reflection-symmetrical double one-port network that exhibits at each port the same impedance value which is unknown but which differs from the impedance value of the second calibration measurement,

a fourth calibration measurement is carried out in respect of a two-port network that consists of a concentrated, complex but unknown series impedance and/or parallel impedance,

and a fifth calibration measurement is carried out in respect of a further two-port network that consists of a concentrated parallel impedance and a concentrated unknown series impedance,

and the unknown scattering parameters of the second, third, fourth and fifth calibration measurements are subsequently calculated from the measured values measured overall.

7. Procedure according to Claim 6,
**characterised in that**
one of the two-port networks of the fourth or fifth calibration measurement is constituted by a known series resistor.

8. Procedure according to Claim 6,
**characterised in that**
one of the two-port networks for the fourth or fifth calibration measurement is an electrical line of known natural impedance, the electrical propagation constant of which may be unknown.

9. Procedure according to Claim 3 or 8,
**characterised in that**
a planar strip line is utilised by way of electrical line.

**Revendications**

1. Procédé pour le calibrage d'un analyseur de réseau présentant deux portes de mesure (6,7) et au moins quatre postes de mesure (8,9,10,11) par la mesure consécutive des paramètres de transmission et de réflexion sur cinq standards de calibrage montés dans n'importe quelle séquence les uns derrière les autres entre les deux portes de mesure (6,7) selon le principe des 15 termes, des valeurs de correction étant calculées à partir de ces valeurs de mesure, qui sont prises en considération lors de mesures d'objet consécutives, dans lequel pour la première mesure de calibrage on utilise comme standard de calibrage une monoporte avec une résistance connue qui est consécutivement branchée sur les deux portes de mesure (6,7),
**caractérisé en ce que** l'on effectue

une deuxième mesure de calibrage sur une double monoporte de réflexion symétrique, de réflexion inconnue.

une troisième mesure de calibrage sur une autre double monoporte de réflexion symétrique, de réflexion inconnue, toutefois différente de la réflexion de la double monoporte de la deuxième mesure de calibrage,

une quatrième mesure de calibrage sur une biporte réciproque de réflexion inconnue,

et une cinquième mesure de calibrage sur une autre biporte réciproque de transmission connue et de réflexion inconnue, toutefois différente de la réflexion de la biporte de la quatrième mesure de calibrage,

et l'on calcule subséquemment les paramètres de dispersion inconnus des deuxième, troisième, quatrième et cinquième mesures de calibrage à partir des valeurs de mesure mesurées au total.

2. Procédé selon la revendication 1,
**caractérisé en ce que**,
la deuxième mesure de calibrage est effectuée sur un circuit ouvert - double monoporte.

**3.** Procédé selon la revendication 2,
**caractérisé en ce que**,
la quatrième mesure de calibrage est effectuée sur une conduite électrique avec une impédance caractéristique connue, dont la constante de propagation électrique peut être inconnue.

**4.** Procédé selon la revendication 2,
**caractérisé en ce que**,
la troisième mesure de calibrage est effectuée sur un court-circuit - double monoporte.

**5.** Procédé selon la revendication 1,
**caractérisé en ce que**,
la quatrième mesure de calibrage est effectuée avec un raccordement direct des deux portes de mesure.

**6.** Procédé pour le calibrage d'un analyseur de réseau présentant deux portes de mesure (6,7) et au moins quatre postes de mesure (8,9,10,11) par la mesure consécutive des paramètres de transmission et de réflexion sur cinq standards de calibrage montés dans n'importe quelle séquence les uns derrière les autres entre les deux portes de mesure (6,7) selon le principe des 15 termes, des valeurs de correction étant calculées à partir de ces valeurs de mesure, qui sont prises en considération lors de mesures d'objet consécutives, dans lequel pour la première mesure de calibrage en tant que standard de calibrage on utilise une monoporte - circuit ouvert,
**caractérisé en ce que**,
l'on effectue

une deuxième mesure de calibrage sur une double monoporte de réflexion symétrique, qui présente sur chaque porte la même valeur d'impédance, toutefois inconnue,

une troisième mesure de calibrage sur une autre double monoporte de réflexion symétrique, qui présente sur chaque porte la même valeur d'impédance, inconnue, toutefois différente de la valeur d'impédance de la deuxième mesure de calibrage,

une quatrième mesure de calibrage sur une biporte qui consiste en une impédance en série et/ou parallèle, concentrée, complexe, toutefois inconnue,

et une cinquième mesure de calibrage sur une autre biporte, qui consiste en une impédance parallèle concentrée et en une impédance de série concentrée, inconnue,

et **en ce que** l'on calcule subséquemment les paramètres de dispersion inconnus des deuxième, troisième, quatrième et cinquième mesure de calibrage à partir des valeurs de mesure mesurées au total.

**7.** Procédé selon la revendication 6,
**caractérisé en ce que**,
l'on forme une des biportes de la quatrième ou cinquième mesure par une résistance de série connue.

**8.** Procédé selon la revendication 6,
**caractérisé en ce que**,
l'une des biportes pour la quatrième ou la cinquième mesure de calibrage est une conduite électrique d'impédance caractéristique connue, dont la constante de propagation électrique peut être inconnue.

**9.** Procédé selon la revendication 3 ou 8,
**caractérisé en ce que**,
comme conduite électrique, on utilise une conduite à ruban planaire.

Fig. 1:

| MURN | Kalibrierstandards | | | | |
|---|---|---|---|---|---|
| | **1.** | **2.** | **3.** | **4.** | **5.** |
| *Name* | MM | UU | RR | N1 | N2 |
| $S_{11} =$ | 0 | $\rho$ | $\gamma$ | ra | na |
| $S_{12} =$ | 0 | 0 | 0 | $\ell$ | t |
| $S_{21} =$ | 0 | 0 | 0 | $\ell$ | t |
| $S_{22} =$ | 0 | $\rho$ | $\gamma$ | rb | nb |
| *Unbek.* | 0 | 1 | 1 | 3 | 3 |

Tab. 1: Struktur der MURN-Kalibrierstandards

| MORN | Kalibrierstandards | | | | |
|---|---|---|---|---|---|
| | **1.** | **2.** | **3.** | **4.** | **5.** |
| *Name* | MM | OO | RR | L | N |
| $S_{11} =$ | 0 | 1 | $\gamma$ | 0 | na |
| $S_{12} =$ | 0 | 0 | 0 | $\ell$ | t |
| $S_{21} =$ | 0 | 0 | 0 | $\ell$ | t |
| $S_{22} =$ | 0 | 1 | $\gamma$ | 0 | nb |
| *Unbek.* | 0 | 0 | 1 | 1 | 3 |

Tab. 2: Struktur der MORN-Kalibrierstandards

| TMRN | Kalibrierstandards | | | | |
|---|---|---|---|---|---|
| | **1.** | **2.** | **3.** | **4.** | **5.** |
| *Name* | MM | UU | RR | T | N |
| $S_{11} =$ | 0 | $\rho$ | $\gamma$ | 0 | na |
| $S_{12} =$ | 0 | 0 | 0 | 1 | t |
| $S_{21} =$ | 0 | 0 | 0 | 1 | t |
| $S_{22} =$ | 0 | $\rho$ | $\gamma$ | 0 | nb |
| *Unbek.* | 0 | 1 | 1 | 0 | 3 |

Tab. 3: Struktur der TMRN-Kalibrierstandards

| MONS | Kalibrierstanaards | | | | |
|---|---|---|---|---|---|
| | 1. | 2. | 3. | 4. | 5. |
| *Name* | MM | OO | SS | UR | N |
| $S_{11}$ = | 0 | 1 | -1 | ra | na |
| $S_{12}$ = | 0 | 0 | 0 | 0 | t |
| $S_{21}$ = | 0 | 0 | 0 | 0 | t |
| $S_{22}$ = | 0 | 1 | -1 | rb | nb |
| *Unbek.* | 0 | 0 | 0 | 2 | 3 |

Tab. 4: Struktur der MONS-Kalibrierstandards

| ZORN | Kalibrierstandards | | | | |
|---|---|---|---|---|---|
| | 1. | 2. | 3. | 4. | 5. |
| *Name* | OO | UU | RR | Z | N |
| $S_{11}$ = | 1 | $\rho$ | $\gamma$ | ra | na |
| $S_{12}$ = | 0 | 0 | 0 | $\ell$ | t |
| $S_{21}$ = | 0 | 0 | 0 | $\ell$ | t |
| $S_{22}$ = | 1 | $\rho$ | $\gamma$ | rb | nb |
| *Unbek.* | 0 | 1 | 1 | 3 | 3 |

Tab. 5: Struktur der ZORN-Kalibrierstandards